# EUROPEAN PATENT APPLICATION

(11) **EP 4 451 806 A1**
(43) Date of publication of application: **23.10.2024**
(21) Application number: 24164271.9
(22) Date of filing: 18.03.2024
(51) Int. Cl.: H05B 45/325, H05B 45/37, H05B 45/50, H05B 47/20

(54) **DIMMING CIRCUIT FOR LED LAMPS**

(30) Priority: 31.03.2023 CN 202310359584
(71) Applicant: Self Electronics Co., Ltd., Ningbo City, Zhejiang 315103 (CN); SELF ELECTRONICS Germany GmbH, 51149 Köln (DE); Lin, Wanjiong, Ningbo City, Zhejiang 315103 (CN)
(72) Inventor: YU, Jianfeng, Ningbo, 315103 (CN); QU, Yang, Ningbo, 315103 (CN); ZHAO, Pengyuan, Ningbo, 315103 (CN); WANG, Linji, Ningbo, 315103 (CN)
(74) Representative: 2K Patentanwälte Blasberg Kewitz & Reichel

(57) **Abstract**

The invention provides a dimming circuit for LED lamps, comprising a control module and a DCDC module, wherein the input end of the control module is connected to receive an external dimming demand information, the output end of the control module is connected with the DCDC module, and a corresponding PWM control signal is generated according to the dimming demand information.

The control module controls the DCDC module according to the PWM control signal, so that the DCDC module outputs corresponding current according to the dimming demand information to drive the LED lamp accordingly. According to the dimming circuit for LED lamps provided by the invention, the DCDC module is controlled by the control module, so that the DCDC module drives the LED lamp according to the current lamp demand information and a proper adjustment of the DCDC current is implemented. According to the invention, a dialing code is not required for adjustment, and the maximum current output by the DCDC module is only limited by the design of the DCDC chip, and the limitation of the impedance and the dial overcurrent capacity of the dialing according to the prior art is avoided.

## Description

The present application claims priority of Chinese patent application no. 202310359584.0 'Dimming circuit for LED lamps', filed on March 31, 2024, the whole content of which is hereby incorporated by reference.

### Technical Field

The invention relates to the field of lamps or luminaires, in particular to a dimming circuit for LED lamps (luminaires).

### Background of Invention

Along with the development of dimming technology, the dimmable lighting is widely applied, and the LED lamps currently on the market are controlled by a DCDC constant voltage-constant current controller (DC-to-DC controller), and the DCDC output current, i.e. the output current after DC-to-DC-conversion) usually needs to be adjusted because different types of LED lamps may have different driving current requirements.

In the prior art, the adjustment of the DCDC output current is generally accomplished by dialing, and the resistance value of the sampling resistor in the DCDC main circuit, which is connected with the main circuit, is changed through dialing, so that the DCDC output current is changed. However, the DCDC circuit is usually limited because the sampling resistance set by the DCDC circuit is fixed and cannot be expanded, and is limited by the over current capability of the dial code.

### Summary of Invention

Accordingly, the technical problem to be solved by the present invention is to overcome the problem that dimming of LED lamps according to the prior art is limited by the dialing code over current capability. In particular the problem to be solved by the present invention is to provide an enhanced and more efficient dimming circuit for LED lamps.

This problem is solved by a dimming circuit for LED lamps as claimed in claim 1. Further advantageous embodiments are the subject-matter of the dependent claims.

According to a first aspect, the present invention provides a dimming circuit for LED lamps, comprising a control module, and a DCDC module, wherein the input end of the control module is externally connected with a dimming demand information (is connected to receive an external dimming demand information), the output end of the control module is connected with the DCDC module, and a corresponding PWM control signal is generated according to the dimming demand information. The control module controls the DCDC module according to the PWM control signal, so that the DCDC module outputs corresponding current according to the dimming demand information to drive the LED lamp accordingly.

In an embodiment, the circuit may further comprise an anti-jamming module provided on the dimming circuit of the LED lamp, wherein the input end of the anti-jamming module is connected with the control module and used for controlling the circuit to operate when the PWM control signal is an AC signal and for stopping the circuit to operate when the PWM control signal is a DC signal.

In an embodiment, a first input end of the anti-jamming module is connected with an output end of the control module, a second input end of the anti-jamming module is connected with an output end of the DCDC module, and an output end of the anti-jamming module is connected with the LED lamp.

In an embodiment, an input end of the anti-jamming module is connected to an output end of the control module, a first output end of the anti-jamming module is connected to an enable end of the DCDC module, and a second output end is connected to an input end of the DCDC module.

In an embodiment, the anti-jamming module may further comprise a first capacitor, a first controlled switch, and a second controlled switch, wherein, the control end of the first controlled switch is connected with the output end of the control module through the first capacitor, the first end of the first controlled switch is connected with the control end of the second controlled switch, and the second end of the first controlled switch is grounded; and the first end of the second controlled switch is connected with the output end of the DCDC module, and the second end of the second controlled switch is connected with the binding post of the LED lamp.

In an embodiment, the anti-jamming module may further comprise a first diode, a Zener diode or voltage stabilizing diode, a second capacitor, a first resistor, a second resistor, and a third resistor, wherein the forward end of the first diode is connected with the control end of the first controlled switch through a first resistor, and the reverse end of the first diode is grounded; the forward end of the voltage stabilizing diode is respectively connected with the first end of the first controlled switch, the second capacitor and the third resistor, and the reverse end of the voltage stabilizing diode is connected with the first end of the second controlled switch; and the other end of the second capacitor is connected with the first end of the first controlled switch through the second resistor.

In an embodiment, the anti-jamming module may further comprise a third capacitor, a third controlled switch and a fourth controlled switch, wherein the control end of the third controlled switch is connected with the output end of the control module through the third capacitor, the first end of the third controlled switch is connected with the control end of the fourth controlled switch, and the second end of the third controlled switch is grounded; and the control end of the fourth controlled switch is externally connected with a power supply, the first end of the fourth controlled switch is connected with the enabling end of the DCDC module, and the second end of the fourth controlled switch is grounded.

In an embodiment, the anti-jamming module may further comprise a second diode, a fourth capacitor, a fourth resistor, and a fifth resistor, wherein the forward end of the second diode is connected with the control end of the third controlled switch through a fourth resistor, and the reverse end of the second diode is connected with the second end of the third controlled switch; one end of the fourth capacitor is connected with the first end of the third controlled switch, the fifth resistor and the control end of the fourth controlled switch respectively, and the other end of the fourth capacitor is grounded.

In an embodiment, the circuit further comprises a power supply circuit that supplies power to the control module and the DCDC module.

In another embodiment, the circuit may further comprise: the input end of the digital-to-analog conversion module is connected with the output end of the control module, the output end of the digital-to-analog conversion module is connected with the input end of the DCDC module, and the digital-to-analog conversion module converts the PWM control signal into an analog signal.

In an embodiment, the digital-to-analog conversion module includes a sixth resistor, a seventh resistor, an eighth resistor, a fifth capacitor, a sixth capacitor, and a seventh capacitor, wherein, one end of the sixth resistor is externally connected with the PWM control signal, and the other end of the sixth resistor is respectively connected with the seventh resistor, the eighth resistor, the fifth capacitor and the sixth capacitor; the other end of the seventh resistor is grounded, the other end of the eighth resistor is connected with the enabling end of the DCDC module, the other end of the fifth capacitor is externally connected with an amplitude modulation pulse width modulation signal, and the other end of the sixth capacitor is grounded; one end of the seventh capacitor is connected with the eighth resistor, and the other end of the seventh capacitor is grounded.

The technical effects accomplished according to the present invention enable in particular the following advantages: the embodiments according to the present invention provide a dimming circuit for LED lamps, wherein a dimming demand information is acquired (obtained) through a control module to determine a current output demand information (e.g. in accordance to current brightness demand of a user), and a corresponding maximum PWM control signal is generated to control the DCDC module, so that the DCDC drives an LED lamp according to the current lamp demand information so as to implement an adjustment of the DCDC current. According to the present invention a dialing code is not required for adjustment, so that the maximum current output by the DCDC is only limited by the design of a DCDC chip, but is not limited by the impedance of the dialing code and the over current capacity of the convention dialing.

### Overview on Drawings

In order to more clearly illustrate the technical solutions according to the present invention as compared to the prior art reference is made to the following detailed description of exemplary specific embodiments and the accompanying drawings. It is noted that the accompanying drawings and the following detailed description of exemplary specific embodiments of the present invention shall not be deemed to be delimiting, and it will be obvious to the skilled person in the art that other equivalent embodiments can also be obtained on the basis of the accompanying drawings without creative labor. In the drawings.
- Fig. 1: is a schematic circuit diagram of a dimming circuit for LED lamps according to an embodiment of the present invention;
- Fig. 2: is a schematic block diagram of a first anti-jamming module according to an embodiment of the present invention;
- Fig. 3: is a schematic block diagram of an example of a first anti-jamming module according to an embodiment of the present invention;
- Fig. 4: is a schematic block diagram of a second anti-jamming module according to an embodiment of the present invention;
- Fig. 5: is a schematic block circuit diagram of a second anti-jamming module according to an embodiment of the present invention; and
- Fig. 6: is a schematic circuit diagram of a digital-to-analog conversion module according to an embodiment of the present invention.

Throughout the drawings, the same reference numerals relate to identical or substantially equivalent features or components.

### Detailed Description of Exemplary Embodiments

The technical solutions provided by the present invention will be described clearly and completely in the following in conjunction with the accompanying drawings, and it is obvious that the embodiments according to the present invention disclosed hereinafter are exemplary embodiments that shall not delimit the scope of the present invention, and it will be obvious to the skilled person in the art that other equivalent embodiments can also be obtained on the basis of the accompanying drawings without creative labor. In the accompanying drawings.

In the prior art, the adjustment of the DCDC output current of LED lamps is usually accomplished by dialing codes, and a common dialing code circuit is used for changing the resistance value of the resistor connected in the main circuit (loop) of the DCDC main circuit. However, on one hand, the current passing through the dialing code circuit is limited due to the self-impedance of the dialing code circuit, and when the current stress of a device is large, the required high current cannot flow. On the other hand, a fixed combination of resistors is implemented through dialing and breaking, and the resistance value of the sampling resistor in the DCDC circuit is fixed and cannot be expanded, so that the dialing code circuit has certain limitations.

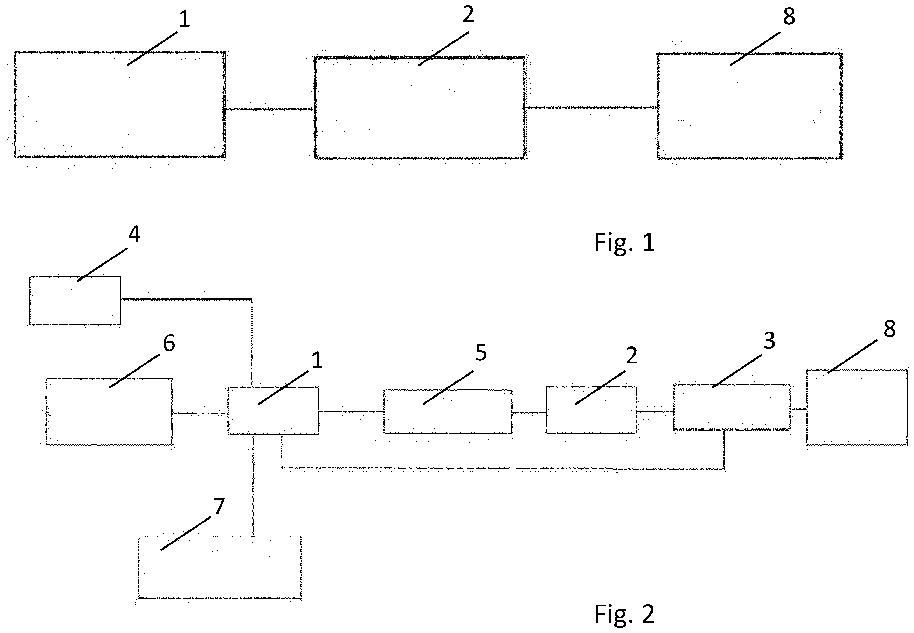

In order to implement a DCDC output current adjustment under high current circulation, an embodiment of the present invention provides a dimming circuit for LED lamps, as shown in Fig. 1, which includes a control module 1 and a DCDC module 2.

The control module 1 has an input end externally connected to receive or obtain dimming demand information, and the output end of the control module 1 is connected with the DCDC module 2, and a corresponding PWM control signal is generated according to the dimming demand information.

The control module 1 controls the DCDC module 2 according to the PWM control signal, so that the DCDC module 2 outputs a corresponding current to drive the associated LED lamp 8 according to the dimming demand information.

In the embodiment of the present invention, the control module 1 is an MCU control module, where the control mode of the control module 1 may be implemented by referring to the control modes of the MCU or other control modules generally known from the prior art, and will not be described hereinafter in more detail. More specifically, the dimming requirement information may include a current gear (conversion factor) requirement information and user brightness demand information, and as shown in Fig. 2, the input end of the control module 1 is respectively connected with a current selection module 6 and an external control input module 7.

The control module 1 collects current gear demand information output from the current selection module 6, wherein the current gear is a gear (current) freely set in a preset current range. The control module 1 generates a corresponding PWM control signal according to the current gear demand information, wherein the control signal is a PWM signal (duty cycle ratio) reaching maximum brightness under the current gear limit.

Through the PWM control signals generated according to different current gear demands so as to meet the control under different current gear demands, the maximum current output by the DCDC module 2 depends only on a DCDC chip structure, without the need to implement the adjustment of the output current through a dialer, so that the adjustment of the output current can be implemented according to the present invention even in the case that the current stress of a device is larger.

In order to meet the brightness demands of different users, the users can input the brightness demands through the external control input module 7, and the control module 1 collects the brightness demand information input by the users and generates PWM control signals corresponding to different brightnesses according to the brightness demand information. For example, when the user brightness demand is 50%, the PWM control signal generated by the control module 1 is a PWM signal corresponding to 50% brightness. PWM control signals corresponding to different brightnesses are generated according to brightness demands of the user, so that dimming requirements of the user under different conditions are met.

By means of the afore-mentioned embodiment, the dimming demand information is collected through the control module to determine the output current demand information in order to generate the corresponding maximum PWM control signal to control the DCDC module, so that the DCDC can drive the LED lamp according to the current demand information of the lamp to realize the adjustment of the DCDC output current, and for this purpose a dialer is not required to be adopted for setting, so that the maximum current output by the DCDC module is limited only by the design of the DCDC chip, but is not limited by the impedance of the dialer, and is not limited by the overcurrent capacity of the dialer.

In an embodiment, as shown in Fig. 2, the circuit may further include an anti-jamming module 3, wherein a first input end of the anti-jamming module 3 is connected with an output end of the control module 1, a second input end of the anti-jamming module 3 is connected with an output end of the DCDC module 2, and an output end of the anti-jamming module 3 is connected with the LED lamp 8. The output of the DCDC module 2 drives the LED lamp 8 after passing through the anti-jamming module 3.

The anti-jamming module 3 synchronously controls (synchronizes) the DCDC module 2 according to the PWM control signal output by the control module 1 so as to prevent the problem that the LED lamp 8 is damaged due to an uncontrolled output current (i.e. a current going out of control) when a full current is output when the control module 1 is jammed (blocked). The anti-jamming module 3 controls the circuit to operate when the PWM control signal is an AC signal, wherein the AC signal is a high-frequency signal; when the PWM control signal is a DC signal, the control circuit stops running, wherein the DC signal is a high level signal or a low level signal.

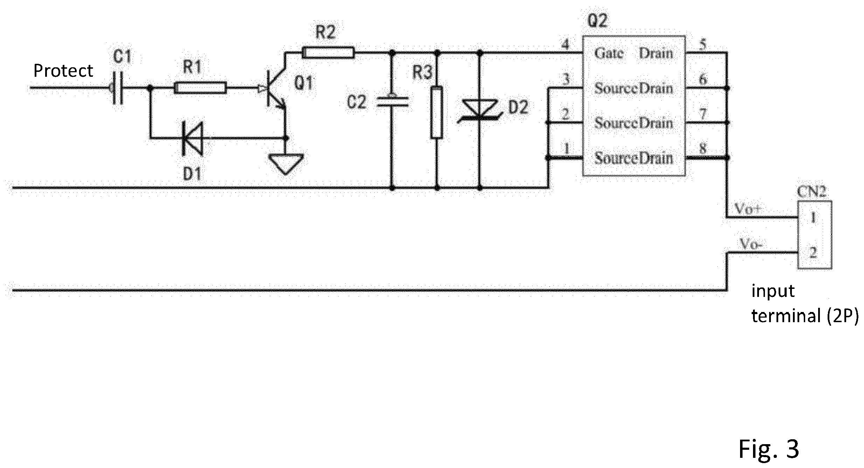

Specifically, as shown in Fig. 3, the anti-jamming module 3 may include a first capacitor C1, a first controlled switch Q1, and a second controlled switch Q2.

The first controlled switch Q1 may be a triode, the second controlled switch Q2 may be a MOS transistor, wherein the control end of the first controlled switch Q1 is connected with the output end of the control module 1 through the first capacitor C 1, the first end is connected with the control end of the second controlled switch Q2, and the second end is grounded.

The first end of the second controlled switch Q2 is connected with the output end of the DCDC module 2, and the second end of the second controlled switch Q2 is connected with the positive electrode of the terminal CN2 of the LED lamp 8.

More specifically, the anti-jamming module 3 may further include a first diode D1, a Zener diode D2, a second capacitor C2, a first resistor R1, a second resistor R2, and a third resistor R3 .

The reverse end of the first diode D1 is connected with the control end of the first controlled switch Q1 through a first resistor R1, and the forward end is grounded.

The forward end of the Zener diode D2 is respectively connected with the first end of the first controlled switch Q1, the second capacitor C2 and the third resistor R3, and the reverse end of the Zener diode D2 is connected with the first end of the second controlled switch Q2.

One end of the second capacitor C2 is connected with the first end of the first controlled switch Q1 through the second resistor R2, and the other end of the second capacitor C2 is connected with the first end of the second controlled switch Q2.

In the embodiment of the present invention, the output end of the control module 1 is the protection port in Fig. 3, and the control module 1 generates a periodic square wave, which, according to the characteristic of the first capacitor C1 to pass through the AC, causes the first controlled switch Q1 to be kept on, and at this time, the second controlled switch Q2 is kept on, so as to cause the DCDC module 2 to output normally. When the control module 1 is jammed (blocked), the protection port of the control module 1 continuously outputs a low level or a high level, which, according to the characteristic of the first capacitor C1 to isolate (block) DC, causes the first controlled switch Q1 to close, and the second controlled switch Q2 is kept closed at the moment, so that when the control module 1 is jammed (blocked), the output of the DCDC module 2 is closed, to avoid the situation that a lamp is burned out caused by the jamming of the control module 1, so that the lamp is protected.

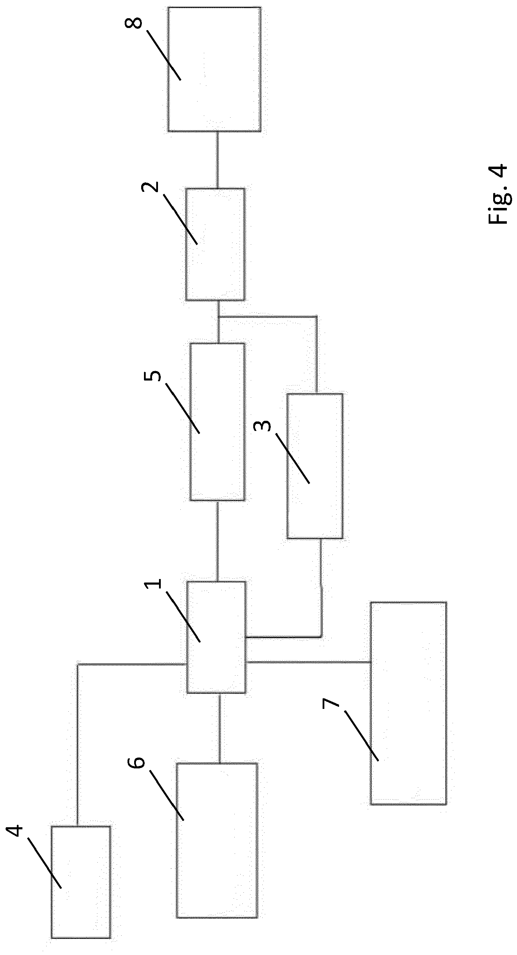

In another embodiment, as shown in Fig. 4, the input end of the anti-jamming module 3 may also be connected to the output end of the control module 1, wherein the first output end is connected to the enabling end of the DCDC module 2, and the second output end is connected to the input end of the DCDC module 2.

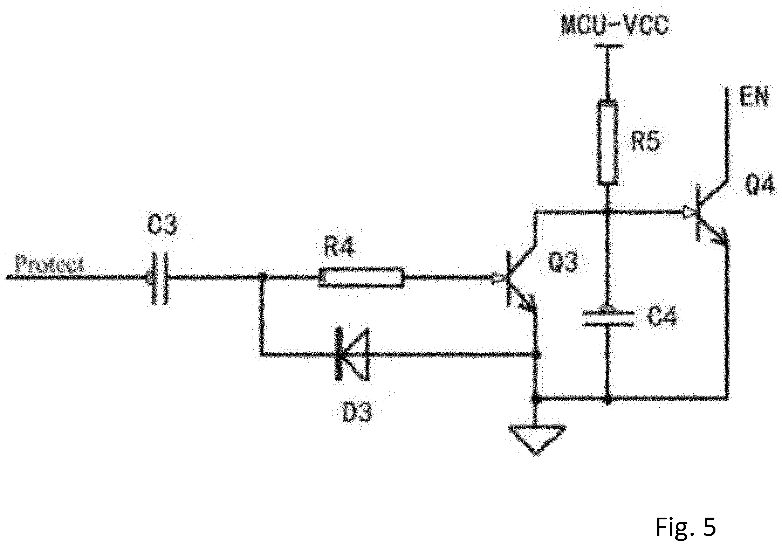

More specifically, as shown in Fig. 5, the anti-jamming module 3 may further include a third capacitor C3, a third controlled switch Q3, and a fourth controlled switch Q4.

The third controlled switch Q3 and the fourth controlled switch Q4 are triodes, wherein the control end of the third controlled switch Q3 is connected with the output end of the control module 1 through a third capacitor C3, the first end is connected with the control end of the fourth controlled switch Q4, and the second end is grounded.

The control end of the fourth controlled switch Q4 is connected with an external power supply, wherein the first end of the fourth controlled switch Q4 is connected with the enabling end of the DCDC module 2, and the second end of the fourth controlled switch Q is grounded.

More specifically, the anti-jamming module 3 may further include a second diode D3, a fourth capacitor C4, a fourth resistor R4, and a fifth resistor R5.

The reverse end of the second diode D3 is connected with the control end of the third controlled switch Q3 through the fourth resistor R4, and the forward end of the second diode D3 is connected with the second end of the third controlled switch Q3. The control end of the fourth controlled switch Q4 is connected with the external power supply through a fifth resistor R5; one end of the fourth capacitor C4 is connected to the first end of the third controlled switch Q3 and the control end of the fourth controlled switch Q4, respectively, and the other end is grounded.

In the embodiments according to the present invention, the protection port of the control module 1 generates a periodic square wave, which, according to characteristic of the third capacitor C3 to pass AC, causes the third controlled switch Q3 to be kept on (conductive), and the fourth controlled switch Q4 is kept off (closed) at the moment, so that the PWM control signal can be loaded normally at the enabling end of the DCDC module 2, and the DCDC module 2 outputs normally. When the control module 1 is jammed or stuck (blocked), the protection port of the control module 1 continuously outputs a low level or a high level, and the third controlled switch Q3 is closed according to the characteristic of the third capacitor C3 to block a DC (direct current), to cause the fourth controlled switch Q4 to be kept on at the moment, so that the enabling end (terminal) of the DCDC module 2 forcibly pulls the PWM control signal to the low level, and the output of the DCDC module 2 is shut down (closed). Therefore, when the control module 1 is jammed or stuck (blocked), the output of the DCDC module 2 is stopped, to thereby avoid the situation that a lamp is burnt out caused by the control module 1 being jammed (blocked), so that the lamp is protected.

In an embodiment of the present invention, as shown in Fig. 2 or Fig. 4, the circuit may further comprise a power supply circuit 4, wherein the power supply circuit 4 supplies power to the control module 1 and the DCDC module 2. The power supply circuit 4 may be an AC power supply, or may be another power supply capable of supplying power to the control module 1.

In an embodiment, as shown in Fig. 2 or Fig. 4, the circuit may further include a digital-to-analog conversion module 5, wherein an input end of the digital-to-analog conversion module 5 is connected to an output end of the control module 1, an output end of the digital-to-analog conversion module 5 is connected to an input end of the DCDC module 2, and the digital-to-analog conversion module 5 converts the PWM control signal into an analog signal.

The PWM control signal output by the control module 1 is converted by the digital-to-analog conversion module 5 and then used to drive the DCDC module 2 in order to enable the DCDC module 2 to drive the LED lamp 8, and the digital-to-analog conversion module 5 thus implements a DCDC analog amplitude dimming and PWM frequency adjustment at low brightness, which helps to solve the problem of insufficient depth of the DCDC amplitude dimming.

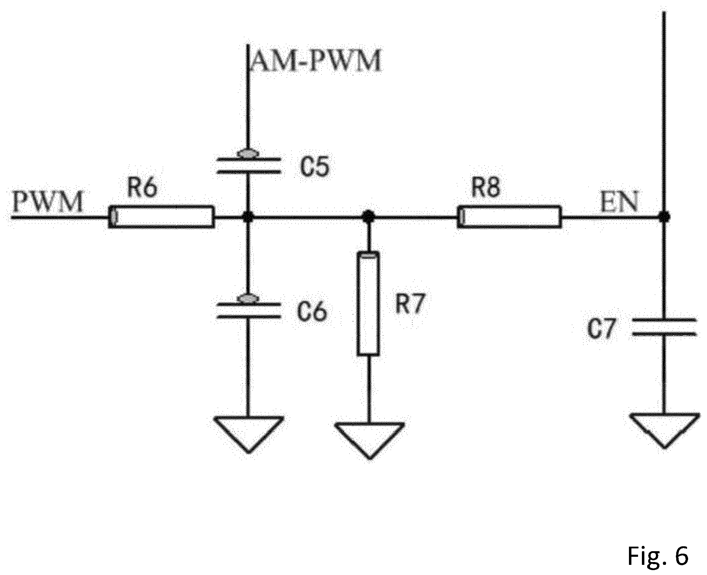

More specifically, as shown in Fig. 6, the digital-to-analog conversion module 5 may include a sixth resistor R6, a seventh resistor R7, an eighth resistor R8, a fifth capacitor C5, a sixth capacitor C6, and a seventh capacitor C7.

One end of the sixth resistor R6 is connected with an external PWM control signal, the other end of the sixth resistor R6 is respectively connected with the seventh resistor R7, the eighth resistor R8, the fifth capacitor C5 and the sixth capacitor C6, the other end of the seventh resistor R7 is grounded. The other end of the eighth resistor R8 is connected with the enabling end of the DCDC module 2, the other end of the fifth capacitor C5 is connected with an external amplitude modulation pulse width modulation signal AM-PWM, the other end of the sixth capacitor C6 is grounded, and one end of the seventh capacitor C7 is connected with the eighth resistor R8, and the other end is grounded.

In the embodiment of the invention, in the case of low brightness, the PWM control signal is charged through the sixth resistor R6 and the sixth capacitor C6, and the sixth capacitor C6, the sixth resistor R6 and the seventh resistor R7 are discharged to thereby adjust the PWM control signal to be converted into a triangle-like wave, and the PWM duty ratio is adjusted to adjust the brightness. And the PWM on time is fixed at extremely low brightness, and the PWM frequency is regulated, so as to implement a dimming to one thousandth of a degree at a low brightness condition. On the other hand, in the case of high brightness, the PWM control signal is charged through the sixth resistor R6, a sixth capacitor C6 and a fifth capacitor C5, wherein the capacitance value of the fifth capacitor C5 is much larger than that of the sixth capacitor C6, and the PWM control signal is converted through the parallel connection of the sixth resistor R6 and a seventh resistor R7, so as to make the PWM control signal converted into a basically stable level signal, and with the change of the PWM duty cycle the amplitude of the enable terminal port level is adjusted or changes to implement a brightness adjustment in the case of high brightness.

It is apparent that the above examples are given by way of illustration only and shall not be deemed to delimit the present invention. Other variations or modifications of the above teachings will be apparent to those of ordinary skill in the art. It is not necessary here nor is it exhaustive of all embodiments. And obvious variations or modifications thereof are contemplated as falling within the scope of the present invention as defined in the appended claims.

### List of Reference numerals

- 1: control module
- 2: DCDC module
- 3: anti-jamming module
- 4: power supply circuit
- 5: digital-to-analog conversion module
- 6: current selection module
- 7: external control input module
- 8: LED lamp
- C1: first capacitor
- C2: second capacitor
- C3: third capacitor
- C4: fourth capacitor
- C5: fifth capacitor
- C6: sixth capacitor
- C7: seventh capacitor
- R1: first resistor
- R2: second resistor
- R3: third resistor
- R4: fourth resistor
- R5: fifth resistor
- R6: sixth resistor
- R7: seventh resistor
- R8: eighth resistor
- Q1: first controlled switch
- Q2: second controlled switch
- Q3: third controlled switch
- Q4: fourth controlled switch
- D1: first diode
- D2: voltage stabilizing diode
- D3: second diode

## Claims

1. A dimming circuit for LED lamps, comprising a control module (1) and a DCDC module (2), wherein,
an input end of the control module (1) is connected to receive an external dimming demand information, an output end of the control module (1) is connected with the DCDC module (2), and the control module (1) is configured to generate a corresponding PWM control signal according to the dimming demand information; and
the control module (1) is configured to control the DCDC module (2) according to the PWM control signal, so that the DCDC module (2) outputs a corresponding current according to the dimming demand information to drive the LED lamp (8) accordingly.

2. The dimming circuit as claimed in claim 1, further comprising an anti-jamming module (3) provided on a dimming circuit of the LED lamp (8), wherein an input end of the anti-jamming module (3) is connected with the control module (1), for controlling the circuit to operate when the PWM control signal is an AC signal and for controlling the circuit to stop operating when the PWM control signal is a DC signal.

3. The dimming circuit as claimed in claim 2, wherein a first input of the anti-jamming module (3) is connected to the output of the control module (1), a second input of the anti-jamming module (3) is connected to the output of the DCDC module (2), and an output of the anti-jamming module (3) is connected to the LED lamp (8).

4. The dimming circuit as claimed in claim 2, wherein an input of the anti-jamming module (3) is connected to the output of the control module (1), a first output is connected to an enabling terminal of the DCDC module (2), and a second output is connected to the input of the DCDC module (2).

5. The dimming circuit as claimed in any of claims 2 to 4, wherein the anti-jamming module (3) comprises a first capacitor (C1), a first controlled switch (Q1) and a second controlled switch (Q2), wherein
a control end of the first controlled switch (Q1) is connected with the output end of the control module (1) through the first capacitor (C1), the first end is connected with the control end of the second controlled switch (Q2), and the second end is grounded; and
the first end of the second controlled switch (Q2) is connected with the output end of the DCDC module (2), and the second end of the second controlled switch (Q2) is connected with a terminal of the LED lamp (8).

6. The dimming circuit as claimed in any of claims 3 to 5, wherein the anti-jamming module (3) further comprises a first diode (D1), a voltage stabilizing diode (D2), a second capacitor (C2), a first resistor (R1), a second resistor (R2) and a third resistor (R3), wherein,
the reverse end of the first diode (D 1) is connected with the control end of the first controlled switch (Q1) through the first resistor (R1), and the forward end is grounded;
the forward end of the voltage stabilizing diode (D2) is respectively connected with the first end of the first controlled switch (Q1), the second capacitor (C2) and the third resistor (R3), and the reverse end of the voltage stabilizing diode (D2) is connected with the first end of the second controlled switch (Q2); and
the other end of the second capacitor (C2) is connected with the first end of the first controlled switch (Q1) through the second resistor (R2).

7. The dimming circuit as claimed in any of claims 4 to 6, wherein the anti-jamming module (3) further comprises a third capacitor (C3), a third controlled switch (Q3) and a fourth controlled switch (Q4), wherein
a control end of the third controlled switch (Q3) is connected with the output end of the control module (1) through the third capacitor (C3), the first end of the third controlled switch (Q3) is connected with the control end of the fourth controlled switch (Q4), and the second end of the third controlled switch (Q3) is grounded; and
the control end of the fourth controlled switch (Q4) is connected with an external power supply, the first end of the fourth controlled switch (Q4) is connected with the enabling end of the DCDC module (2), and the second end of the fourth controlled switch (Q4) is grounded.

8. The dimming circuit as claimed in claim 7, wherein the anti-jamming module (3) further comprises a second diode (D3), a fourth capacitor (C4), a fourth resistor (R4) and a fifth resistor (R5), wherein,
the reverse end of the second diode (D3) is connected with the control end of the third controlled switch (Q3) through a fourth resistor (R4), and the forward end of the second diode (D3) is connected with the second end of the third controlled switch (Q3);
one end of the fourth capacitor (C4) is respectively connected with the first end of the third controlled switch (Q3), the fifth resistor (R5) and the control end of the fourth controlled switch (Q4), and the other end of the fourth capacitor (C4) is grounded.

9. The dimming circuit as claimed in any of the preceding claims, further comprising:
a power supply circuit (4), for supplying power to the control module (1) and the DCDC module (2).

10. The dimming circuit as claimed in any of the preceding claims, further comprising:
a digital-to-analog conversion module (5), wherein
an input end of the digital-to-analog conversion module (5) is connected with the output end of the control module (1), and
the output end of the digital-to-analog conversion module (5) is connected with the input end of DCDC module (2), wherein
the digital-to-analog conversion module (5) is configured to convert the PWM control signal into an analog signal.

11. The dimming circuit as claimed in claim 10, wherein the digital-to-analog conversion module (5) comprises a sixth resistor (R6), a seventh resistor (R7), an eighth resistor (R8), a fifth capacitor (C5), a sixth capacitor (C6) and a seventh capacitor (C7), wherein,
one end of the sixth resistor (R6) is connected with an external PWM control signal, and the other end of the sixth resistor is respectively connected with the seventh resistor (R7), the eighth resistor (R8), the fifth capacitor (C5) and the sixth capacitor (C6);
the other end of the seventh resistor (R7) is grounded, the other end of the eighth resistor (R8) is connected with the enabling end of the DCDC module (2), the other end of the fifth capacitor (C5) is connected with an external amplitude modulation pulse width modulation signal (AM-PWM), and the other end of the sixth capacitor (C6) is grounded; and
one end of the seventh capacitor (C7) is connected with the eighth resistor (R8) and the other end of the seventh capacitor is grounded.
